(19) Europäisches Patentamt
European Patent Office
Office européen des brevets

(11) **EP 2 847 798 B1**

(12) **FASCICULE DE BREVET EUROPEEN**

(45) Date de publication et mention
de la délivrance du brevet:
**29.08.2018 Bulletin 2018/35**

(21) Numéro de dépôt: **13722373.1**

(22) Date de dépôt: **07.05.2013**

(51) Int Cl.:
***H01L 31/042*** *(2014.01)*

(86) Numéro de dépôt international:
**PCT/EP2013/059439**

(87) Numéro de publication internationale:
**WO 2013/167564 (14.11.2013 Gazette 2013/46)**

(54) **MODULE PHOTOVOLTAÏQUE ET PROCÉDÉ DE REALISATION D'UN TEL MODULE**

PHOTOVOLTAIK-MODUL UND DESSEN HERSTELLUNGSVERFAHREN

PHOTOVOLTAIC MODULE AND METHOD FOR PRODUCING SUCH A MODULE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.05.2012 FR 1254337**

(43) Date de publication de la demande:
**18.03.2015 Bulletin 2015/12**

(73) Titulaire: **Commissariat à l'Énergie Atomique
et aux Énergies Alternatives
75015 Paris (FR)**

(72) Inventeurs:
• **VOARINO, Philippe**
**F-06000 Nice (FR)**
• **LEFILLASTRE, Paul**
**F-75013 Paris (FR)**

(74) Mandataire: **Brevalex
95, rue d'Amsterdam
75378 Paris Cedex 8 (FR)**

(56) Documents cités:
**EP-A2- 1 172 863       WO-A2-2009/138868
WO-A2-2013/136160    US-B1- 6 265 242
US-B1- 6 525 262**

EP 2 847 798 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

## DOMAINE TECHNIQUE

L'invention concerne un module photovoltaïque dans lequel la disposition des cellules photovoltaïques au sein du module est fonction de la valeur de leur courant de court-circuit $I_{SC}$. L'invention concerne également un procédé de réalisation d'un tel module photovoltaïque.

## ÉTAT DE LA TECHNIQUE ANTÉRIEURE

Un module photovoltaïque, également appelé panneau photovoltaïque ou panneau solaire, comporte une pluralité de cellules photovoltaïques reliées entre elles électriquement afin que le module photovoltaïque forme un générateur de courant continu, le courant étant généré par la conversion photovoltaïque d'un rayonnement de photons reçu par les cellules. Lors de la réalisation d'un tel module photovoltaïque, les cellules photovoltaïques du module sont choisies de préférence afin qu'elles soient le plus semblables possible les unes par rapport aux autres, en termes de caractéristiques électriques de conversion photovoltaïque. Ceci est destiné à limiter le plus possible la partie du flux lumineux reçu par les cellules qui est non converti en électricité par les cellules, mais également pour ne pas créer de points chauds au sein du module. De tels points chauds sont des sources de dégradations prématurées des modules et peuvent conduire à des échauffements locaux, voir des incendies. De plus, le rendement global du module photovoltaïque est affecté lorsque les cellules du module ne sont pas parfaitement appairées, c'est-à-dire choisies en fonction de la similitude de leurs paramètres électriques.

Le document "Analysis and Control of Mismatch Power Loss in Photovoltaic Arrays" de David Roche et al., Progress in Photovoltaïcs: research and applications, vol.3, 115-127, 1995, décrit différentes stratégies pour appairer les cellules photovoltaïques au sein d'un module photovoltaïque.

Le document US 6,265,242 B1 décrit différents critères de sélection et classification de cellules solaires pour utilisation dans un module photovoltaïque, ledit module ayant au moins deux groupes de cellules que présentent des caractéristiques différentes.

## EXPOSÉ DE L'INVENTION

Un but de la présente invention est de proposer un module photovoltaïque au sein duquel la localisation, ou l'emplacement, de chacune des cellules photovoltaïques est optimisée afin d'augmenter la capacité de conversion énergie solaire / énergie électrique du module photovoltaïque.

Pour cela, il est proposé un module photovoltaïque comportant des premières cellules photovoltaïques et des deuxièmes cellules photovoltaïques, reliées électriquement entre elles et disposées les unes à côté des autres, dans lequel les premières cellules photovoltaïques comportent chacune un courant de court-circuit de valeur inférieure ou égale à celle du courant de court-circuit de chacune des deuxièmes cellules photovoltaïques du module photovoltaïque et sont disposées au niveau de bords et/ou d'extrémités du module photovoltaïque.

La présente invention concerne un module photovoltaïque comportant des premières cellules photovoltaïques et des deuxièmes cellules photovoltaïques, reliées électriquement entre elles et disposées les unes à côté des autres, dans lequel les premières cellules photovoltaïques comportent chacune un courant de court-circuit de valeur inférieure à celle du courant de court-circuit de chacune des deuxièmes cellules photovoltaïques du module photovoltaïque et sont disposées au niveau de bords et/ou d'extrémités du module photovoltaïque.

Du fait que les cellules photovoltaïques qui présentent les plus faibles courants de court-circuit, appelées premières cellules photovoltaïques, sont disposées au niveau d'un ou plusieurs bords du module photovoltaïque, qui correspond à la ou aux zones du module où la lumière réfléchie est la plus forte, les autres cellules photovoltaïques, appelées deuxièmes cellules photovoltaïques et qui présentent les plus forts courants de court-circuit, qui sont disposées par exemple au centre du module sont donc destinées à être sur-éclairées par rapport aux premières cellules photovoltaïques.

Les premières cellules photovoltaïques sont disposées au niveau des bords et/ou des extrémités du module photovoltaïque, correspondant aux zones du module où se produit le plus fort éclairement en raison notamment de la réflexion et de la diffusion lumineuse du « backsheet » (film de protection se trouvant à l'arrière du module photovoltaïque), des interconnexions métalliques et du cadre du module photovoltaïque.

Ainsi, pour un lot donné de cellules photovoltaïques destinées à être utilisées dans le module photovoltaïque, le rendement de conversion du module photovoltaïque est optimisé en choisissant judicieusement les emplacements des cellules photovoltaïques au sein du module en fonction de la valeur de leur courant de court circuit $I_{SC}$. Une telle optimisation permet d'améliorer le courant de court-circuit du module photovoltaïque, se traduisant par un gain en courant de court-circuit du module pouvant être supérieur à environ 1 %.

L'invention peut s'appliquer à n'importe quel type de cellules photovoltaïques.

Il est également proposé un module photovoltaïque comportant une pluralité de cellules photovoltaïques reliées électriquement entre elles et disposées les unes à côté des autres, dans lequel les cellules photovoltaïques disposées au niveau des bords et/ou des extrémités du module photovoltaïque comportent chacune un courant de court-circuit de valeur inférieure ou égale à celle du courant de court-circuit de chacune des autres cellules photovoltaïques du module photovoltaïque qui ne sont pas disposées au niveau des bords et/ou des extrémités du module.

Une cellule photovoltaïque disposée au niveau d'un des bords du module photovoltaïque peut correspondre à une cellule qui comporte au moins un de ses côtés qui ne soit pas disposé en regard d'au moins une autre des cellules photovoltaïques du module. Une cellule photovoltaïque disposée au niveau d'une des extrémités du module photovoltaïque peut correspondre à une cellule qui comporte au moins deux de ses côtés qui ne soient pas disposés en regard d'au moins une autre des cellules photovoltaïques du module.

Il est également proposé un module photovoltaïque comportant des cellules photovoltaïques d'un premier groupe disposées au niveau de bords extérieurs du module photovoltaïque et en périphérie, c'est-à-dire autour, de cellules photovoltaïques d'un deuxième groupe, dans lequel chacune des cellules photovoltaïques du premier groupe comporte un courant de court-circuit de valeur inférieure ou égale à celle du courant de court-circuit de chacune des cellules photovoltaïques du deuxième groupe.

Chacune des cellules photovoltaïques du module photovoltaïque peut comporter un facteur de forme supérieur à environ 0,70 (ou 70 %), et de préférence supérieur ou égal à environ 0,75 (ou 75 %). Un tel facteur de forme correspond au facteur de forme propre à chaque cellule, mesuré avant la mise en module des cellules.

Les cellules photovoltaïques du module photovoltaïque peuvent être disposées les unes à côté des autres en formant une matrice de forme rectangulaire de $M \times N$ cellules, le module photovoltaïque comportant $2(M+N-2)$ premières cellules photovoltaïques, $M$ et $N$ étant des nombres entiers supérieurs ou égaux à 3. Dans ce cas, le module photovoltaïque peut comporter $M.N - 2(M+N-2)$ deuxièmes cellules photovoltaïques. $M$ et $N$ peuvent être de valeurs différentes ou similaires.

Dans ce cas, quatre premières cellules photovoltaïques peuvent être disposées au niveau des coins de la matrice de forme rectangulaire et peuvent comporter chacune un courant de court-circuit de valeur inférieure ou égale à celle du courant de court-circuit de chacune des autres premières cellules photovoltaïques. Les coins de la matrice peuvent correspondre aux extrémités du module photovoltaïque.

Il est également possible que $M$ ou $N$ ait une valeur inférieure à 3. Ainsi, il est possible d'avoir par exemple $N = 1$, les cellules photovoltaïques du module pouvant être dans ce cas disposées sous la forme d'une rangée de $M$ cellules. Les premières cellules photovoltaïques, au nombre de deux, peuvent être les cellules disposées aux extrémités de la rangée, même lorsqu'il y a plus de deux cellules qui ont un courant de court-circuit inférieur aux autres cellules. Il en est de même si $N = 2$, les premières cellules photovoltaïques, au nombre de quatre, pouvant être les cellules disposées aux extrémités des deux rangées de cellules. Dans ce type de configuration, le terme « en périphérie de » peut être compris comme signifiant « aux extrémités de ».

Les cellules photovoltaïques du module photovoltaïque peuvent être disposées les unes à côté des autres en formant une ou deux rangées de $P$ cellules photovoltaïques, le module photovoltaïque comportant deux ou quatre premières cellules photovoltaïques disposées aux extrémités respectivement de la ou des rangées de $P$ cellules photovoltaïques, $P$ étant un nombre entier supérieur ou égal à 3.

Il est également possible que le module photovoltaïque ait une forme autre que rectangulaire, par exemple hexagonale ou même « ronde » (les cellules étant disposées les unes à côté des autres selon un motif formant approximativement un disque). On peut positionner les premières cellules photovoltaïques ayant un courant de court-circuit inférieur à ceux des autres cellules en bordure du module.

Il est également proposé un procédé de réalisation d'un module photovoltaïque, comportant au moins les étapes de :

- sélection, parmi un ensemble de cellules photovoltaïques destinées à faire partie du module photovoltaïque, de premières cellules photovoltaïques comportant chacune un courant de court-circuit de valeur inférieure ou égale à celle du courant de court-circuit de chacune de deuxièmes cellules photovoltaïques correspondant aux cellules non sélectionnées de l'ensemble des cellules photovoltaïques ;

- disposition de l'ensemble des cellules photovoltaïques les unes à côté des autres et telles que les premières cellules photovoltaïques soient disposées au niveau de bords et/ou d'extrémités du module photovoltaïque ;

- réalisation de liaisons électriques entre l'ensemble des cellules photovoltaïques.

Il est également proposé un procédé de réalisation d'un module photovoltaïque, comportant au moins les étapes de :

- sélection, parmi un ensemble de cellules photovoltaïques destinées à faire partie du module photovoltaïque, de cellules photovoltaïques d'un premier groupe destinées à être disposées au niveau de bords extérieurs du module photovoltaïque telle que chacune des cellules photovoltaïques du premier groupe comporte un courant de court-circuit de valeur inférieure ou égale à celle du courant de court-circuit de chacune des cellules photovoltaïques d'un deuxième groupe correspondant aux cellules non sélectionnées de l'ensemble de cellules photovoltaïques ;

- disposition des cellules photovoltaïques du premier groupe en périphérie des cellules photovoltaïques du deuxième groupe.

L'invention concerne également un procédé de réalisation d'un module photovoltaïque, comportant au moins les étapes de :

- sélection, parmi un ensemble de cellules photovoltaïques destinées à faire partie du module photovoltaïque, de premières cellules photovoltaïques comportant chacune un courant de court-circuit de valeur inférieure à celle du courant de court-circuit de chacune de deuxièmes cellules photovoltaïques correspondant aux cellules non sélectionnées de l'ensemble des cellules photovoltaïques ;
- disposition de l'ensemble des cellules photovoltaïques les unes à côté des autres et telles que les premières cellules photovoltaïques soient disposées au niveau de bords et/ou d'extrémités du module photovoltaïque ;
- réalisation de liaisons électriques entre l'ensemble des cellules photovoltaïques.

Il est également proposé un procédé de réalisation d'un module photovoltaïque, comportant au moins les étapes de :

- sélection, parmi une pluralité de cellules photovoltaïques destinées à faire partie du module photovoltaïque, de celles comportant les plus faibles courants de court-circuit ;
- disposition de ladite pluralité de cellules photovoltaïques les unes à côté des autres telles que les cellules photovoltaïques destinées à être disposées au niveau des bords et/ou des extrémités du module photovoltaïque correspondent à celles précédemment sélectionnées.

Les cellules photovoltaïques sont de préférence reliées électriquement entre elles en série.

Le procédé peut comporter en outre, avant l'étape de sélection des premières cellules photovoltaïques, une étape de sélection dudit ensemble de cellules photovoltaïques parmi un nombre plus important de cellules photovoltaïques telle que les cellules dudit l'ensemble de cellules photovoltaïques comportent chacune un facteur de forme supérieur à environ 0,70, et avantageusement supérieur ou égal à 0,75.

L'ensemble des cellules photovoltaïques du module photovoltaïque peuvent être disposées les unes à côté des autres en formant une matrice de forme rectangulaire de $M \times N$ cellules, et le module photovoltaïque peut comporter $2(M+N-2)$ premières cellules photovoltaïques, $M$ et $N$ étant des nombres entiers supérieurs ou égaux à 3.

Dans ce cas, le procédé peut comporter en outre, entre l'étape de sélection des premières cellules photovoltaïques et l'étape de disposition des cellules photovoltaïques du module, une étape de sélection, parmi les premières cellules photovoltaïques, de quatre cellules photovoltaïques comportant les plus faibles courants de court-circuit, lesdites quatre cellules photovoltaïques étant ensuite disposées au niveau des coins de la matrice de forme rectangulaire.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un module photovoltaïque, objet de la présente invention, selon un mode de réalisation particulier;
- la figure 2 représente deux modules photovoltaïques dont l'un correspond à l'objet de la présente invention selon un mode de réalisation particulier ;
- la figure 3 représente les valeurs des facteurs de forme et des courants de court-circuit des cellules photovoltaïques des deux modules représentés sur la figure 2 ;
- la figure 4 représente les caractéristiques I(U) des deux modules représentés sur la figure 2 ;
- la figure 5 représente un module photovoltaïque, objet de la présente invention, selon un autre mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

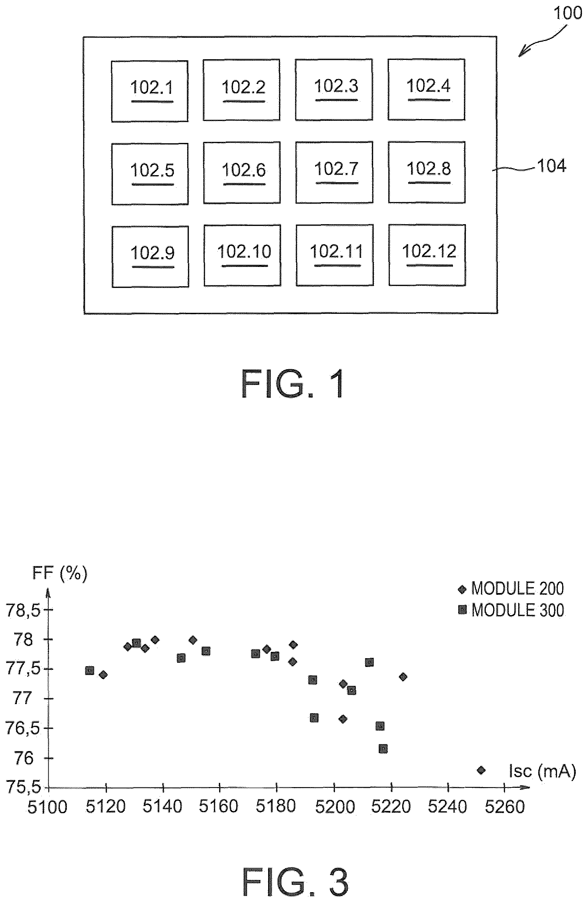

On se réfère tout d'abord à la figure 1 qui représente schématiquement un module photovoltaïque 100 selon un mode de réalisation particulier.

Le module photovoltaïque 100 comporte douze cellules photovoltaïques 102.1 - 102.12 reliées électriquement entre elles, ici en série, et assemblées mécaniquement sur une face d'un châssis 104 sous la forme d'une matrice rectangulaire de dimensions $3 \times 4$ (3 lignes et 4 colonnes). Le type et la technologie des cellules photovoltaïques 102.1 - 102.12 peuvent être choisis en fonction de l'application envisagée du module photovoltaïque 100 ainsi que des performances et du coût souhaités du module. Ainsi, les cellules photovoltaïques 102.1 - 102.12 peuvent être composées de silicium monocristallin, amorphe ou multicristallin, ou bien être composées d'un ou plusieurs autres semi-conducteurs. Elles peuvent également correspondre à des cellules à homojonction ou à hétérojonction, comporter des contacts électriques en faces avant et arrière ou uniquement en face arrière, etc.

Les cellules photovoltaïques 102.1 - 102.12 du module photovoltaïque 100 présentent un facteur de forme supérieur ou égal à environ 0,70, ou 70%, et avantageusement supérieur ou égal à environ 0,75, ou 75 %,. Le facteur de forme (FF, ou « Fill Factor » en anglais) d'une cellule photovoltaïque correspond au rapport

$$\frac{Pm}{V_{OC} \times I_{SC}}$$, avec *Pm* correspondant à la puissance maximale de la cellule, $V_{OC}$ la tension en circuit ouvert de la cellule, et $I_{SC}$ le courant en court-circuit de la cellule.

La position de chacune des cellules photovoltaïques 102.1 - 102.12 au sein de la matrice rectangulaire est choisie en fonction de la valeur du courant de court-circuit $I_{SC}$ de chaque cellule afin d'augmenter le courant de court-circuit global du module photovoltaïque 100, et augmenter ainsi le rendement de conversion photovoltaïque du module 100. Pour cela, on sélectionne, parmi l'ensemble des cellules destinées à former le module photovoltaïque 100, celles qui présentent les plus faibles valeurs de courant de court-circuit $I_{SC}$. Lors de l'assemblage des cellules photovoltaïques sur le châssis 104, celles-ci sont disposées au niveau des bords du module 100.

Ainsi, sur l'exemple de la figure 1, parmi les douze cellules photovoltaïques 102.1 - 102.12, les dix d'entre elles qui sont disposées au niveau des bords extérieurs du module photovoltaïque 100 (correspondant ici aux cellules 102.1, 102.2, 102.3, 102.4, 102.5, 102.8, 102.9, 102.10, 102.11 et 102.12) correspondent aux dix cellules qui présentent les plus faibles valeurs de courant de court-circuit parmi les douze cellules 102.1 - 102.12. On choisit donc, parmi l'ensemble initial des douze cellules photovoltaïques, les dix qui présentent les plus faibles courants de court-circuit et qui seront disposées au niveau des bords du module 100. Ces dix premières cellules photovoltaïques peuvent être vues comme disposées au niveau des bords du module photovoltaïque 100 et en périphérie, ou autour, de deuxièmes cellules photovoltaïques correspondant ici aux deux cellules 102.6 et 102.7. Chacune des premières cellules photovoltaïques comporte au moins un côté qui n'est pas disposé en regard d'une autre cellule photovoltaïque du module 100 (contrairement aux cellules 102.6 et 102.7 qui comportent leurs quatre côtés disposés chacun en regard d'une autre cellule photovoltaïque du module).

Afin d'augmenter encore le courant de court-circuit du module photovoltaïque 100, on peut placer avantageusement, au niveau des coins du module photovoltaïque 100, les quatre premières cellules qui présentent les plus faibles courants de court-circuit parmi les douze cellules. Sur l'exemple de la figure 1, ces quatre cellules correspondent aux cellules référencées 102.1, 102.4, 102.9 et 102.12.

Le module photovoltaïque 100 peut comporter un nombre plus ou moins important de cellules photovoltaïques. Par exemple, l'ensemble des cellules photovoltaïques du module photovoltaïque peuvent être disposées les unes à côté des autres en formant une matrice de forme rectangulaire de $M \times N$ cellules, *M* et *N* étant des nombres entiers supérieurs ou égaux à 3. Dans ce cas, les premières cellules photovoltaïques, c'est-à-dire celles qui sont disposées au niveau des bords extérieurs du module photovoltaïques, sont au nombre de *2(M+N-2)*. Le nombre de deuxièmes cellules photovoltaïques, c'est-à-dire celles qui sont entourées par les premières cellules, sont au nombre de *M.N - 2(M+N-2)*.

Par exemple, pour un module photovoltaïque comportant 60 cellules disposées sous la forme d'une matrice rectangulaire, on identifie les 28 cellules qui présentent les plus faibles valeurs de courant de court-circuit. Ces 28 cellules, appelées premières cellules photovoltaïques, correspondent à celles qui seront disposées en périphérie, au niveau des bords extérieurs du module photovoltaïque. Les quatre cellules qui présenteront les plus faibles valeurs de courant de court-circuit seront avantageusement disposées au niveau des coins du module. Ce module peut par exemple être réalisé sous la forme d'une matrice rectangulaire formée de six lignes de dix cellules photovoltaïques, chaque cellule étant par exemple de forme carrée. Les quatre premières cellules photovoltaïques disposées dans les coins présentent des valeurs de courant de court-circuit ne dépassant pas une valeur maximale appelée $I_{SC1}$. Les 24 autres premières cellules photovoltaïques disposées au niveau des bords extérieurs du module présentent des valeurs de courant de court-circuit supérieures à $I_{SC1}$ et ne dépassent pas une valeur maximale appelée $I_{SC2}$. Enfin, les 32 cellules photovoltaïques restantes, appelées deuxièmes cellules photovoltaïques, qui sont disposées au centre du module photovoltaïque et entourées par les 28 premières cellules photovoltaïques, présentent des valeurs de courant de court-circuit supérieures à $I_{SC2}$.

Dans l'exemple ci-dessus, les cellules photovoltaïques sont donc réparties en trois catégories : celles de plus faibles valeurs de courant de court-circuit (de valeurs $I_{SC}$ telles que $I_{SC} \leq I_{SC1}$) qui sont disposées au niveau des coins du module, puis celles présentant des valeurs de courant de court-circuit un peu plus élevées (de valeurs $I_{SC}$ telles que $I_{SC1} < I_{SC} \leq I_{SC2}$) disposées au niveau des bords du module, et enfin celles qui présentent les valeurs de court-circuit les plus élevées (de valeurs $I_{SC}$ telles que $I_{SC2} < I_{SC}$) disposées au centre du module.

Lorsque le module photovoltaïque est de forme rectangulaire, il peut être avantageux de répartir les cellules photovoltaïques en quatre catégories : celles de plus faibles valeurs de courant de court-circuit (de valeurs $I_{SC}$ telles que $I_{SC} \leq I_{SC1}$) qui sont disposées au niveau des coins du module, puis celles présentant des valeurs de courant de court-circuit un peu plus élevées (de valeurs $I_{SC}$ telles que $I_{SC1} < I_{SC} \leq I_{SC2}$) disposées au niveau des bords du module s'étendant dans le sens de la longueur du module, puis celles présentant des valeurs de courant de court-circuit encore un peu plus élevées (de valeurs $I_{SC}$ telles que $I_{SC2} < I_{SC} \leq I_{SC}$) disposées au niveau des bords du module s'étendant dans le sens de la largeur du module, et enfin celles qui présentent les valeurs de court-circuit les plus élevées (de valeurs $I_{SC}$ telles que $I_{SC3} < I_{SC}$) disposées au centre du module.

Ainsi, pour un module photovoltaïque comportant 120 cellules disposées sous la forme d'une matrice rectangulaire comprenant par exemple six lignes de vingt cellules photovoltaïques, chaque cellule étant par exemple de forme rectangulaire, les quatre premières cellules photovoltaïques qui présentent les plus faibles valeurs de courant de court-circuit parmi l'ensemble des 120 cellules sont disposées au niveau des quatre coins du module. Ces quatre premières cellules photovoltaïques présentent des valeurs de courant de court-circuit ne dépassant pas une valeur maximale appelée $I_{SC1}$. 36 autres premières cellules photovoltaïques sont disposées au niveau des bords extérieurs du module s'étendant dans le sens de la longueur du module (par exemple les bords supérieur et inférieur du module) et présentent des valeurs de courant de court-circuit supérieures à $I_{SC1}$ et qui ne dépassent pas une valeur maximale appelée $I_{SC2}$. 8 autres premières cellules photovoltaïques sont disposées au niveau de bords extérieurs du module s'étendant dans le sens de la largeur du module (par exemple les bords latéraux du module) et présentent des valeurs de courant de court-circuit supérieures à $I_{SC2}$ et ne dépassant par une valeur maximale appelée $I_{SC3}$.

Enfin, les 72 cellules photovoltaïques restantes, appelées deuxièmes cellules photovoltaïques, qui sont disposées au centre du module photovoltaïque et entourées par les 48 premières cellules photovoltaïques, présentent des valeurs de courant de court-circuit supérieures à $I_{SC3}$.

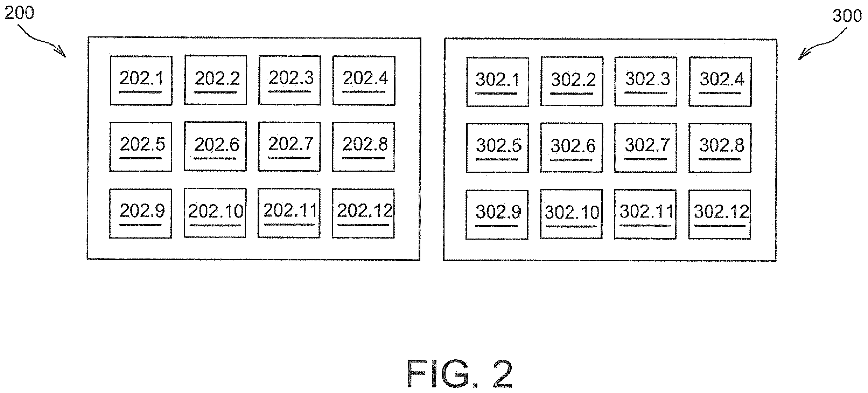

On décrit maintenant la réalisation et la comparaison des performances de deux modules photovoltaïques 200 et 300, le module 200 étant réalisé en disposant les cellules photovoltaïques présentant les plus faibles courants de court-circuit au niveau des bords extérieurs du module 200, tandis que le module 300 est réalisé en disposant les cellules photovoltaïques présentant les plus forts courants de court-circuit au niveau des bords extérieurs du module 300. Ces deux modules 200 et 300 sont représentés sur la figure 2.

Afin de réaliser une comparaison objective des performances des deux modules 200 et 300, les cellules photovoltaïques utilisées pour réaliser les deux modules photovoltaïques 200 et 300 sont issues d'un même lot de cellules, de technologies identiques, destinées à réaliser des modules photovoltaïques sensiblement de même puissance. Parmi l'ensemble des cellules du lot, une première sélection est réalisée afin de ne conserver, pour la réalisation des deux modules 200 et 300, que des cellules photovoltaïques présentant un facteur de forme supérieur ou égal à environ 0,70, et de préférence supérieur ou égal à environ 0,75.

La figure 3 représente les valeurs des facteurs de forme *FF* (en ordonnées) en fonction des valeurs des courants de court-circuit $I_{SC}$ (en abscisses) des 24 cellules sélectionnées pour réaliser les deux modules 200 et 300. Les douze losanges représentent les valeurs de ces caractéristiques pour chacune des douze cellules photovoltaïques du module 200, tandis que les douze carrés représentent les valeurs de ces caractéristiques pour les douze cellules photovoltaïques du module 300. Avec cette figure, on voit que les valeurs moyennes des facteurs de forme et des courants de court-circuit des cellules photovoltaïques des deux modules 200 et 300 sont sensiblement similaires. On voit également que dans chacun des modules 200 et 300, la cellule photovoltaïque limitante, correspondant à la cellule photovoltaïque qui comporte la plus faible valeur de courant de court-circuit, est presque identique (valeurs de courant de court-circuit très proches et de facteur de forme quasi-identiques) pour les deux modules.

Le tableau ci-dessous indique, pour chacun des modules 200 et 300, la somme des courants de court-circuit $I_{SC}$ des cellules photovoltaïques du module, ainsi que la moyenne et l'écart type des courants de court-circuit $I_{SC}$ et des facteurs de forme initiaux *FF* des cellules du module.

|  | Module 200 | Module 300 |
|---|---|---|
| Somme $I_{SC}$ (mA) | 62094,53 | 62138,86 |
| Moyenne $I_{SC}$ (mA) | 5174,54 | 5178,24 |
| Ecart-type $I_{SC}$ (mA) | 42,25 | 34,67 |
| Moyenne FF (%) | 77,45 | 77,3 |
| Ecart-type FF (%) | 0,65 | 0,57 |

Les modules 200 et 300 comportent chacun douze cellules photovoltaïques, respectivement référencées 202.1 - 202.12 pour le module 200 et 302.1 - 302.12 pour le module 300, disposées sous la forme d'une matrice 3 × 4, de manière analogue aux cellules 102.1 - 102.12 du module 100. Dans le module 200, se sont donc les cellules photovoltaïques 202.6 et 202.7, qui sont entourées par les autres cellules 202.1 - 202.5 et 202.8 - 202.12, qui présentent les plus forts courants de court-circuit, respectivement égaux à environ 5251 mA et 5223 mA. Les valeurs des courants de court-circuit des autres cellules 202.1 - 202.5 et 202.8 - 202.12 sont comprises entre environ 5119 mA et 5202 mA. Au contraire, dans le module 300, se sont les cellules photovoltaïques 302.6 et 302.7, qui sont entourées par les autres cellules 302.1 - 302.5 et 302.8 - 302.12, qui présentent les plus faibles courants de court-circuit, respectivement égaux à environ 5114 mA et 5130 mA, les valeurs des courants de court-circuit des autres cellules 302.1 - 302.5 et 302.8 - 302.12 étant comprises entre environ 5146 mA et 5216 mA.

Dans le module 200, les cellules présentent les meilleures capacités de conversion photovoltaïque sont donc disposées au centre du module. L'image en électroluminescence du module 200 en fonctionnement montre une zone plus lumineuse au centre (au niveau des deux cellules 202.6 et 202.7) qu'au bord du module. Dans le module 300, les cellules présentent les meilleures capacités de conversion photovoltaïque sont disposées au niveau des bords du module. L'image en électroluminescence du module 300 en fonctionnement est plus homogène que celle du module 200.

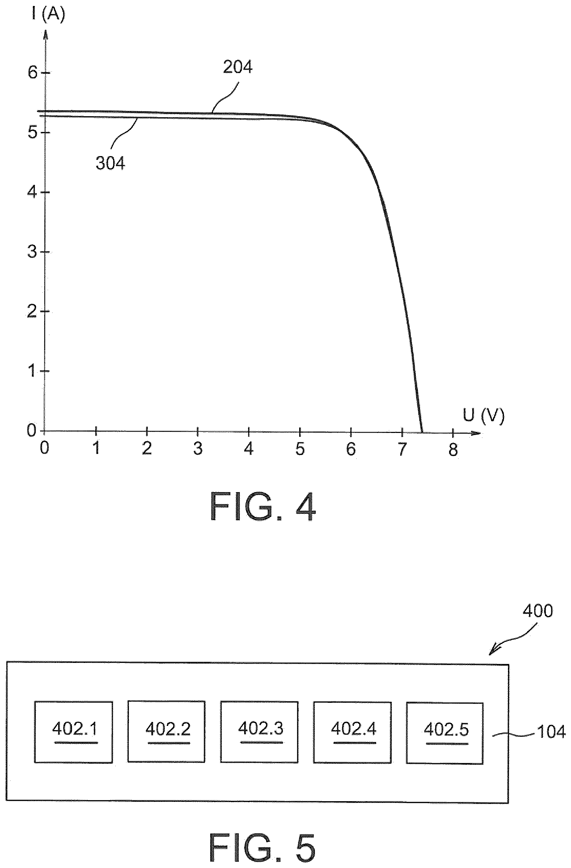

Les courbes 204 et 304 représentées sur la figure 4 correspondent respectivement aux caractéristiques I(U) des modules 200 et 300. Ainsi, on voit que la valeur du courant de court-circuit du module 200 est égale à 5,322 A, tandis que celle du module 300 est égale à 5,254 A, ce qui représente un gain en courant de court circuit d'environ 1,3 %. On voit donc que, pour un ensemble de cellules photovoltaïques destinées à servir à la réalisation d'un module photovoltaïque, la disposition des cellules photovoltaïques de plus faibles valeurs de courants de court-circuit au niveau des bords du module permet d'augmenter le courant de court-circuit du module, et donc d'augmenter sa capacité de conversion photovoltaïque.

La figure 5 représente un autre exemple de réalisation d'un module photovoltaïque 400 dans lequel la disposition des cellules photovoltaïques est optimisée en fonction des valeurs des courants de court-circuit de ces cellules.

Le module photovoltaïque 400 comporte cinq cellules photovoltaïques référencées 402.1 - 402.5 disposées sous la forme d'une seule rangée de cinq cellules. Parmi ces cinq cellules photovoltaïques, les deux cellules 402.1 et 402.5 disposées aux extrémités de la rangée sont choisies comme étant celles, parmi les cinq cellules 402.1 - 402.5, qui comportent les plus faibles courants de court-circuit. Les deux cellules 402.1 et 402.5 correspondent donc aux premières cellules photovoltaïques qui sont disposées au niveau des zones du module où la lumière réfléchie est la plus forte, les autres cellules photovoltaïques 402.2 - 402.4, appelées deuxièmes cellules photovoltaïques et qui présentent les plus forts courants de court-circuit, sont disposées au centre du module et sont donc destinées à être sur-éclairées par rapport aux premières cellules photovoltaïques.

En variante, le module photovoltaïque pourrait comporter deux rangées de cellules photovoltaïques. Dans ce cas, les quatre cellules qui seraient disposées aux extrémités des deux rangées seraient choisies comme étant celles, parmi l'ensemble des cellules du module, qui comportent les plus faibles courants de court-circuit.

## Revendications

**1.** Module photovoltaïque (100, 200, 400) comportant des premières cellules photovoltaïques (102.1 - 102.5 ; 102.8 - 102.12 ; 202.1 - 202.5 ; 202.8 - 202.12 ; 402.1 ; 402.5) et des deuxièmes cellules photovoltaïques (102.6 - 102.7 ; 202.6 - 202.7 ; 402.2 - 402.4), reliées électriquement entre elles et disposées les unes à côté des autres, dans lequel les premières cellules photovoltaïques (102.1 - 102.5 ; 102.8 - 102.12 ; 202.1 - 202.5 ; 202.8 - 202.12 ; 402.1 ; 402.5) comportent chacune un courant de court-circuit de valeur inférieure à celle du courant de court-circuit de chacune des deuxièmes cellules photovoltaïques (102.6 - 102.7 ; 202.6 - 202.7 ; 402.2 - 402.4) du module photovoltaïque (100, 200, 400) et sont disposées au niveau de bords et/ou d'extrémités du module photovoltaïque (100, 200, 400).

**2.** Module photovoltaïque (100, 200, 400) selon la revendication 1, dans lequel chacune des cellules photovoltaïques (102.1 - 102.12 ; 202.1 - 202.12 ; 402.1 - 402.5) du module photovoltaïque (100, 200, 400) comporte un facteur de forme supérieur à environ 0,70.

**3.** Module photovoltaïque (100, 200) selon l'une des revendications précédentes, dans lequel les cellules photovoltaïques (102.1 - 102.12 ; 202.1 - 202.12) du module photovoltaïque (100, 200) sont disposées les unes à côté des autres en formant une matrice de forme rectangulaire de $M \times N$ cellules, le module photovoltaïque (100, 200) comportant $2(M+N-2)$ premières cellules photovoltaïques (102.1 - 102.5 ; 102.8 - 102.12 ; 202.1 - 202.5 ; 202.8 - 202.12), $M$ et $N$ étant des nombres entiers supérieurs ou égaux à 3.

**4.** Module photovoltaïque (100, 200) selon la revendication 3, dans lequel quatre premières cellules photovoltaïques (102.1, 102.4, 102.9, 102.12, 202.1, 202.4, 202.9, 202.12) sont disposées au niveau des coins de la matrice de forme rectangulaire et comportent chacune un courant de court-circuit de valeur inférieure ou égale à celle du courant de court-circuit de chacune des autres premières cellules photovoltaïques (102.2, 102.3, 102.5, 102.8, 102.10, 102.11, 202.2, 202.3, 202.5, 202.8, 202.10, 202.11).

**5.** Module photovoltaïque (400) selon l'une des revendications 1 ou 2, dans lequel les cellules photovoltaïques (402.1 - 402.5) du module photovoltaïque (400) sont disposées les unes à côté des autres en formant une ou deux rangées de $P$ cellules photovoltaïques (402.1 - 402.5), le module photovoltaïque (400) comportant deux ou quatre premières cellules photovoltaïques (402.1 ; 402.5) disposées aux extrémités respectivement de la ou des rangées de $P$ cellules photovoltaïques (402.1 - 402.5), $P$ étant un nombre entier supérieur ou égal à 3.

**6.** Procédé de réalisation d'un module photovoltaïque (100, 200, 400), comportant au moins les étapes de :

- sélection, parmi un ensemble de cellules photovoltaïques (102.1 - 102.12 ; 202.1 - 202.12 ; 402.1 - 402.5) destinées à faire partie du module photovoltaïque (100, 200, 400), de premières cellules photovoltaïques (102.1 - 102.5 ; 102.8 - 102.12 ; 202.1 - 202.5 ; 202.8 - 202.12 ; 402.1 ; 402.5) comportant chacune un courant de court-circuit de valeur inférieure à celle du courant de court-circuit de chacune de deuxièmes cellules photovoltaïques (102.6 - 102.7 ; 202.6 - 202.7 ; 402.2 - 402.4) correspondant aux cellules non sélectionnées de l'ensemble des cellules photovoltaïques (102.1 - 102.12 ; 202.1 - 202.12 ; 402.1 - 402.5) ;
- disposition de l'ensemble des cellules photovoltaïques (102.1 - 102.12 ; 202.1 - 202.12 ; 402.1 - 402.5) les unes à côté des autres et telles que les premières cellules photovoltaïques (102.1 - 102.5 ; 102.8 - 102.12 ; 202.1 - 202.5 ; 202.8 - 202.12 ; 402.1; 402.5) soient disposées au niveau de bords et/ou d'extrémités du module photovoltaïque (100, 200, 400) ;
- réalisation de liaisons électriques entre l'ensemble des cellules photovoltaïques (102.1 - 102.12 ; 202.1 - 202.12 ; 402.1 - 402.5).

**7.** Procédé selon la revendication 6, comportant en outre, avant l'étape de sélection des premières cellules photovoltaïques (102.1 - 102.5 ; 102.8 - 102.12 ; 202.1 - 202.5 ; 202.8 - 202.12 ; 402.1 ; 402.5), une étape de sélection dudit ensemble de cellules photovoltaïques (102.1 - 102.12 ; 202.1 - 202.12 ; 402.1 - 402.5) parmi un nombre plus important de cellules photovoltaïques telle que les cellules dudit l'ensemble de cellules photovoltaïques (102.1 - 102.12 ; 202.1 - 202.12 ; 402.1 - 402.5) comportent chacune un facteur de forme supérieur à environ 0,70.

**8.** Procédé selon l'une des revendications 6 ou 7, dans lequel l'ensemble des cellules photovoltaïques (102.1 - 102.12; 202.1 - 202.12) du module photovoltaïque (100, 200) sont disposées les unes à côté des autres en formant une matrice de forme rectangulaire de $M \times N$ cellules, le module photovoltaïque (100, 200) comportant $2(M+N-2)$ premières cellules photovoltaïques (102.1 - 102.5 ; 102.8 - 102.12 ; 202.1 - 202.5 ; 202.8 - 202.12), $M$ et $N$ étant des nombres entiers supérieurs ou égaux à 3.

**9.** Procédé selon la revendication 8, comportant en outre, entre l'étape de sélection des premières cellules photovoltaïques (102.1 - 102.5 ; 102.8 - 102.12 ; 202.1 - 202.5 ; 202.8 - 202.12) et l'étape de disposition des cellules photovoltaïques (102.1 - 102.12 ; 202.1 - 202.12) du module (100, 200), une étape de sélection, parmi les premières cellules photovoltaïques (102.1 - 102.5 ; 102.8 - 102.12 ; 202.1 - 202.5 ; 202.8 - 202.12), de quatre cellules photovoltaïques (102.1, 102.4, 102.9, 102.12, 202.1, 202.4, 202.9, 202.12) comportant les plus faibles courants de court-circuit, lesdites quatre cellules photovoltaïques (102.1, 102.4, 102.9, 102.12, 202.1, 202.4, 202.9, 202.12) étant ensuite disposées au niveau des coins de la matrice de forme rectangulaire.

**10.** Procédé selon l'une des revendications 6 ou 7, dans lequel les cellules photovoltaïques (402.1 - 402.5) du module photovoltaïque (400) sont disposées les unes à côté des autres en formant une ou deux rangées de $P$ cellules photovoltaïques (402.1 - 402.5), le module photovoltaïque (400) comportant deux ou quatre premières cellules photovoltaïques (402.1 ; 402.5) disposées aux extrémités respectivement de la ou des rangées de $P$ cellules photovoltaïques (402.1 - 402.5), $P$ étant un nombre entier supérieur ou égal à 3.

**Patentansprüche**

**1.** Photovoltaikmodul (100, 200, 400), umfassend erste Photovoltaikzellen (102.1-102.5; 102.8-102.12; 202.1-202.5; 202.8-202.12; 402.1; 402.5) und zweite Photovoltaikzellen (102.6-102.7; 202.6-202.7; 402.2-402.4), die elektrisch miteinander verbunden und nebeneinander angeordnet sind, wobei die ersten Photovoltaikzellen (102.1-102.5; 102.8-102.12; 202.1-202.5; 202.8-202.12; 402.1; 402.5) jeweils einen Kurzschlussstrom mit einem Wert umfassen, der kleiner ist als jener des Kurzschlussstroms von jeder der zweiten Photovoltaikzellen (102.6-102.7; 202.6-202.7; 402.2-402.4) des Photovoltaikmoduls (100, 200, 400) und im Bereich von Rändern und/oder Enden des Photovoltaikmoduls (100, 200, 400) angeordnet sind.

**2.** Photovoltaikmodul (100, 200, 400) nach Anspruch 1, wobei jede der Photovoltaikzellen (102.1-102.12; 202.1-202.12; 402.1-402.5) des Photovoltaikmoduls (100, 200, 400) einen Formfaktor umfasst, der größer als ungefähr 0,70 ist.

**3.** Photovoltaikmodul (100, 200) nach einem der vorhergehenden Ansprüche, wobei die Photovoltaikzellen (102.1-102.12; 202.1-202.12) des Photovoltaikmoduls (100, 200) nebeneinander angeordnet sind, wobei sie eine Matrix von rechteckiger Form mit $M \times N$ Zellen bilden, wobei das Photovoltaikmodul (100, 200) $2(M+N-2)$ erste Photovoltaikzellen (102.1-102.5; 102.8-102.12; 202.1-202.5; 202.8-202.12) umfasst, wobei $M$ und $N$ ganze Zahlen größer oder gleich 3 sind.

4. Photovoltaikmodul (100, 200) nach Anspruch 3, wobei vier erste Photovoltaikzellen (102.1, 102.4, 102.9, 102.12, 202.1, 202.4, 202.9, 202.12) im Bereich der Ecken der Matrix von rechteckiger Form angeordnet sind und jeweils einen Kurzschlussstrom mit einem Wert umfassen, der kleiner oder gleich jenem des Kurzschlussstroms von jeder der anderen ersten Photovoltaikzellen (102.2, 102.3, 102.5, 102.8, 102.10, 102.11, 202.2, 202.3, 202.5, 202.8, 202.10, 202.11) ist.

5. Photovoltaikmodul (400) nach einem der Ansprüche 1 oder 2, wobei die Photovoltaikzellen (402.1-402.5) des Photovoltaikmoduls (400) nebeneinander angeordnet sind, wobei sie eine oder zwei Reihen von *P* Photovoltaikzellen (402.1-402.5) bilden, wobei das Photovoltaikmodul (400) zwei oder vier erste Photovoltaikzellen (402.1; 402.5) umfasst, die an den jeweiligen Enden der Reihe(n) von *P* Photovoltaikzellen (402.1-402.5) angeordnet sind, wobei *P* eine ganze Zahl größer oder gleich 3 ist.

6. Verfahren zur Herstellung eines Photovoltaikmoduls (100, 200, 400), umfassend wenigstens die folgenden Schritte:

- Auswählen, aus einer Gesamtheit von Photovoltaikzellen (102.1-102.12; 202.1-202.12; 402.1-402.5), die Teil des Photovoltaikmoduls (100, 200, 400) sein sollen, von ersten Photovoltaikzellen (102.1-102.5; 102.8-102.12; 202.1-202.5; 202.8-202.12; 402.1; 402.5), die jeweils einen Kurzschlussstrom mit einem Wert umfassen, der kleiner ist als jener des Kurzschlussstroms von jeder der zweiten Photovoltaikzellen (102.6-102.7; 202.6-202.7; 402.2-402.4) entsprechend den nicht ausgewählten Zellen der Gesamtheit der Photovoltaikzellen (102.1-102.12; 202.1-202.12; 402.1-402.5);
- Anordnen der Gesamtheit der Photovoltaikzellen (102.1-102.12; 202.1-202.12; 402.1-402.5) nebeneinander und derart, dass die ersten Photovoltaikzellen (102.1-102.5; 102.8-102.12; 202.1-202.5; 202.8-202.12; 402.1; 402.5) im Bereich von Rändern und/oder Enden des Photovoltaikmoduls (100, 200, 400) angeordnet sind;
- Herstellen von elektrischen Verbindungen zwischen der Gesamtheit der Photovoltaikzellen (102.1-102.12; 202.1-202.12; 402.1-402.5).

7. Verfahren nach Anspruch 6, ferner umfassend, vor dem Schritt des Auswählens der ersten Photovoltaikzellen (102.1-102.5; 102.8-102.12; 202.1-202.5; 202.8-202.12; 402.1; 402.5) einen Schritt des Auswählens der Gesamtheit von Photovoltaikzellen (102.1-102.12; 202.1-202.12; 402.1-402.5) aus einer größeren Zahl von Photovoltaikzellen derart, dass die Zellen der Gesamtheit von Photovoltaikzellen (102.1-102.12; 202.1-202.12; 402.1-402.5) jeweils einen Formfaktor umfassen, der größer als ungefähr 0,70 ist.

8. Verfahren nach einem der Ansprüche 6 oder 7, wobei die Gesamtheit der Photovoltaikzellen (102.1-102.12; 202.1-202.12) des Photovoltaikmoduls (100, 200) nebeneinander angeordnet sind, wobei sie eine Matrix von rechteckiger Form mit *M x N* Zellen bilden, wobei das Photovoltaikmodul (100, 200) *2(M+N-2)* erste Photovoltaikzellen (102.1-102.5; 102.8-102.12; 202.1-202.5; 202.8-202.12) umfasst, wobei *M* und *N* ganze Zahlen größer oder gleich 3 sind.

9. Verfahren nach Anspruch 8, ferner umfassend, zwischen dem Schritt des Auswählens der ersten Photovoltaikzellen (102.1-102.5; 102.8-102.12; 202.1-202.5; 202.8-202.12) und dem Schritt des Anordnens der Photovoltaikzellen (102.1-102.12; 202.1-202.12) des Moduls (100, 200), einen Schritt des Auswählens, aus den ersten Photovoltaikzellen (102.1-102.5; 102.8-102.12; 202.1-202.5; 202.8-202.12), von vier Photovoltaikzellen (102.1, 102.4, 102.9, 102.12, 202.1, 202.4, 202.9, 202.12), die die niedrigsten Kurzschlussströme umfassen, wobei die vier Photovoltaikzellen (102.1, 102.4, 102.9, 102.12, 202.1, 202.4, 202.9, 202.12) anschließend im Bereich der Ecken der Matrix von rechteckiger Form angeordnet werden.

10. Verfahren nach einem der Ansprüche 6 oder 7, wobei die Photovoltaikzellen (402.1-402.5) des Photovoltaikmoduls (400) nebeneinander angeordnet werden, wobei sie eine oder zwei Reihen von P Photovoltaikzellen (402.1-402.5) bilden, wobei das Photovoltaikmodul (400) zwei oder vier erste Photovoltaikzellen (402.1; 402.5) umfasst, die jeweils an den Enden der Reihe(n) von P Photovoltaikzellen (402.1-402.5) angeordnet sind, wobei P eine ganze Zahl größer oder gleich 3 ist.

**Claims**

1. Photovoltaic module (100, 200, 400) comprising first photovoltaic cells (102.1 - 102.5; 102.8 - 102.12; 202.1 - 202.5; 202.8 - 202.12; 402.1; 402.5) and second photovoltaic cells (102.6 - 102.7; 202.6 - 202.7; 402.2 - 402.4), electrically connected to each other and arranged adjacent to each other, in which each of the first photovoltaic cells (102.1 - 102.5; 102.8 - 102.12; 202.1 - 202.5; 202.8 - 202.12; 402.1; 402.5) has a short circuit current with a value less than the value of the short circuit current of each of the second photovoltaic cells (102.6 - 102.7; 202.6 - 202.7; 402.2 - 402.4) of the photovoltaic module (100, 200, 400) and are arranged at edges and/or ends of the photovoltaic module (100, 200, 400).

2. Photovoltaic module (100, 200, 400) according to claim 1, in which each photovoltaic cell (102.1 - 102.12; 202.1 - 202.12; 402.1 - 402.5) of the photovoltaic module (100, 200, 400) has a fill factor greater than about 0.70.

3. Photovoltaic module (100, 200) according to any one of the previous claims, in which the photovoltaic cells (102.1 - 102.12; 202.1 - 202.12) of the photovoltaic module (100, 200) are arranged adjacent to each other to form a rectangular-shaped matrix of $M \times N$ cells, the photovoltaic module (100, 200) comprising *2(M+N-2)* first photovoltaic cells (102.1 - 102.5; 102.8 - 102.12; 202.1 - 202.5; 202.8 - 202.12), where *M* and *N* are integers greater than or equal to 3.

4. Photovoltaic module (100, 200) according to claim 3, in which four first photovoltaic cells (102.1, 102.4, 102.9, 102.12, 202.1, 202.4, 202.9, 202.12) are arranged in the corners of the rectangular-shaped matrix and the value of the short circuit current of each of said four first photovoltaic cells is less than or equal to the value of the short circuit current of each of the other first photovoltaic cells (102.2, 102.3, 102.5, 102.8, 102.10, 102.11, 202.2, 202.3, 202.5, 202.8, 202.10, 202.11).

5. Photovoltaic module (400) according to any one of claims 1 or 2, in which the photovoltaic cells (402.1 - 402.5) of the photovoltaic module (400) are arranged adjacent to each other to form one or two rows of P photovoltaic cells (402.1 - 402.5), the photovoltaic module (400) comprising two or four first photovoltaic cells (402.1; 402.5) arranged at the ends of the row(s) of *P* photovoltaic cells (402.1 - 402.5), where *P* is an integer greater than or equal to 3.

6. Method of producing a photovoltaic module (100, 200, 400), comprising at least the following steps:

   - select first photovoltaic cells (102.1 - 102.5; 102.8 - 102.12; 202.1 - 202.5; 202.8 - 202.12; 402.1; 402.5) among a set of photovoltaic cells (102.1 - 102.12; 202.1 - 202.12; 402.1 - 402.5) that will form part of the photovoltaic module (100, 200, 400), in which the value of the short circuit current for each first photovoltaic cell is less than the value of the short circuit current of each of the second photovoltaic cells (102.6 - 102.7; 202.6 - 202.7; 402.2 - 402.4) corresponding to cells that are not selected among the set of photovoltaic cells (102.1 - 102.12; 202.1 - 202.12; 402.1 - 402.5);

   - arrange the set of photovoltaic cells (102.1 - 102.12; 202.1 - 202.12; 402.1 - 402.5) adjacent to each other such that the first photovoltaic cells (102.1 - 102.5; 102.8 - 102.12; 202.1 - 202.5; 202.8 - 202.12; 402.1; 402.5) are arranged at edges and/or ends of the photovoltaic module (100, 200, 400);

   - make electrical connections between the set of photovoltaic cells (102.1 - 102.12; 202.1 - 202.12; 402.1 - 402.5).

7. Method according to claim 6, also comprising, before the step to select the first photovoltaic cells (102.1 - 102.5; 102.8 - 102.12; 202.1 - 202.5; 202.8 - 202.12; 402.1; 402.5), a step of selection of said set of photovoltaic cells (102.1 - 102.12; 202.1 - 202.12; 402.1 - 402.5) from among a larger number of photovoltaic cells such that the fill factor of each of the cells of said set of photovoltaic cells (102.1 - 102.12; 202.1 - 202.12; 402.1 - 402.5) is greater than about 0.70.

8. Method according to one of claims 6 or 7, in which the set of photovoltaic cells (102.1 - 102.12; 202.1 - 202.12) of the photovoltaic module (100, 200) are arranged adjacent to each other to form a rectangular-shaped matrix with $M \times N$ cells, the photovoltaic module (100, 200) comprising *2(M+N-2)* first photovoltaic cells (102.1 - 102.5; 102.8 - 102.12; 202.1 - 202.5; 202.8 - 202.12), where *M* and *N* are integers greater than or equal to 3.

9. Method according to claim 8, also comprising a step to select four photovoltaic cells (102.1, 102.4, 102.9, 102.12, 202.1, 202.4, 202.9, 202.12) among the first photovoltaic cells (102.1 - 102.5; 102.8 - 102.12; 202.1 - 202.5; 202.8 - 202.12), between the step to select the first photovoltaic cells (102.1 - 102.5; 102.8 - 102.12; 202.1 - 202.5; 202.8 - 202.12) and the step to arrange the photovoltaic cells (102.1 - 102.12; 202.1 - 202.12) of the module (100, 200), the values of the short circuit currents of these four photovoltaic cells being the lowest, said four photovoltaic cells (102.1, 102.4, 102.9, 102.12, 202.1, 202.4, 202.9, 202.12) then being positioned at the corners of the rectangular matrix.

10. Method according to either claim 6 or 7, in which the photovoltaic cells (402.1 - 402.5) of the photovoltaic module (400) are arranged adjacent to each other to form one or two rows of *P* photovoltaic cells (402.1 - 402.5), the photovoltaic module (400) comprising two or four first photovoltaic cells (402.1; 402.5) arranged at the ends of the row(s) of *P* photovoltaic cells (402.1 - 402.5), where *P* is an integer greater than or equal to 3.

# FIG. 1

# FIG. 3

EP 2 847 798 B1

| 202.1 | 202.2 | 202.3 | 202.4 |
| 202.5 | 202.6 | 202.7 | 202.8 |
| 202.9 | 202.10 | 202.11 | 202.12 |

200

| 302.1 | 302.2 | 302.3 | 302.4 |
| 302.5 | 302.6 | 302.7 | 302.8 |
| 302.9 | 302.10 | 302.11 | 302.12 |

300

FIG. 2

I (A)

6 —

204

304

5 —

4 —

3 —

2 —

1 —

0 ——————————————————→ U (V)

0　1　2　3　4　5　6　7　8

FIG. 4

400

402.1　402.2　402.3　402.4　402.5　104

FIG. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6265242 B1

**Littérature non-brevet citée dans la description**

- **DAVID ROCHE et al.** Analysis and Control of Mismatch Power Loss in Photovoltaic Arrays. *Progress in Photovoltaïcs: research and applications,* 1995, vol. 3, 115-127